# EUROPEAN PATENT APPLICATION

(11) **EP 0 903 828 A1**
(43) Date of publication of application: **24.03.1999**
(21) Application number: 97830463.2
(22) Date of filing: 23.09.1997
(51) Int. Cl.: H02H 9/04

(54) **Improved device for the protection of an integrated circuit against electrostatic discharges**

(71) Applicant: STMicroelectronics S.r.l., 20041 Agrate Brianza (Milano) (IT)
(72) Inventor: Ravanelli, Enrico M.A., 20052 Monza (Milano) (IT)

(57) **Abstract**

An improved device for protecting an integrated circuit from electrostatic discharges, comprising a bipolar transistor Q1 of the NPN type, connected between a terminal (Pad) T1 to be protected and a supply line (Supply Rail) T2 which is normally the main supply line to the integrated circuit.

The transistor emitter is connected to the terminal T1, the collector to the line T2, and the base to the circuit ground GND.

## Description

This invention relates to devices for protecting integrated circuits from electrostatic discharges, and in particular to a protection device of compact size for mixed-technology integrated circuits operated on low supply voltages.

It is a recognized fact that the contact pads of an integrated circuit may inadvertently come in contact with electrically charged objects, both during their fabrication and assembly to a host circuit, or while in operation. Thus, differences in electric potential may establish between different areas or portions of the integrated circuit of sufficient magnitude to damage or destroy thin dielectrics, such as gate oxides of field-effect transistors of the MOS type, provided in the device.

Thus, upon the difference in potential due to electrostatic factors exceeding the dielectric strength of the gate insulation, a MOS transistor is put out of use by the electrostatic discharge through the insulation.

For example, in a CMOS technology integrated circuit having a minimum gate size of 1.2µm, this destructive effect may already occur at voltages in the 12V range, that is, at much lower values than those produced by electrostatic discharges in some cases. And moreover, avalanche reverse conduction phenomena may set in which result in the junctions breaking down.

Various measures for protecting the input and output terminals of an integrated circuit against electrostatic discharges are known.

Some of these utilize resistors in series, or diodes in series or parallel, which are integrated to the substrate of the IC circuit iself to limit the currents due to electrostatic discharges, and which are essentially directed to protect the input terminals.

Other designs, of greater circuit complexity, make use of thyristor structures, or SCRs (Silicon Controlled Rectifiers), and can be applied to protect both the input and output terminals, with some possible modifications to lower their triggering voltage.

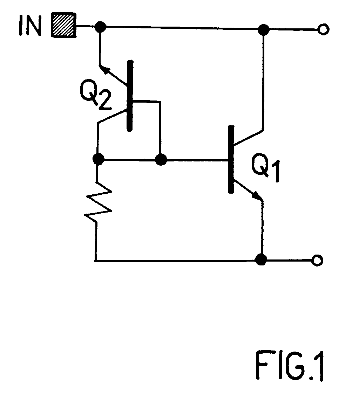

Figure 1 of the drawings appended to this specification shows an input protection circuit for circuits of the BiCMOS type, i.e. integrated with technologies of the mixed type.

Transistors Q1 and Q2 form in combination an equivalent structure of a Zener diode connected between an input terminal IN and a ground GND of the integrated circuit.

This type of ESD (ElectroStatic Discharge) protection and its operation are described, for example, in a book "BiCMOS Technology and Applications", Second Edition by A.R. Alvarez, Cypress Semiconductor Corp.

This is a highly compact protection scheme which can be readily integrated by a process of the BiCMOS type, and is quite effective where a protection device is provided for each terminal of the integrated circuit likely to come in contact with external objects.

In the instance of devices integrated by mixed-type, in particular BiCMOS, processes which provide for an epitaxial layer to be grown onto the surface of a monocrystalline silicon substrate, ESD protectors may, as the skilled persons in the art will readily recognize, interfere with proper operation of the circuit if the epitaxial wells of the protectors are connected directly to the terminals to be protected.

In this case, during an electrostatic discharge, those wells may act as parasitic collectors for substrate currents (a parasitic NPN transistor is activated in the event of a ground loop), and result in a latch-up, that is a regenerative phenomenon with destructive consequences which is caused by parasitic bipolar structures of the SCR type.

In addition, the parasitic well capacitance may produce an antenna effect and disturbance of the switching type which can alter the functionality of a circuit linked to the pad having an ESD protector connected to it.

The underlying technical problem of this invention is to provide a protection transistor structure against electrostatic discharges, for mixed technology epitaxial layer devices, which structure is immune to latch-up and electromagnetic interference.

This technical problem is solved by an ESD protector as previously indicated and defined in the characterizing parts of the appended claims to this specification.

The features and advantages of an ESD protector according to the invention will be apparent from the following description of an embodiment thereof, given by way of non-limitative example with reference to the accompanying drawings.

In the drawings:
Figure 1 shows a circuit diagram of a conventional protection device as mentioned in the foregoing;
Figure 2 is a circuit diagram of an ESD protector according to this invention;
Figure 3 is a cross-sectional view taken through the meaningful portion of an ESD protection structure according to the invention; and
Figure 4 shows the equivalent circuit of the emitter-base junction of an NPN transistor incorporated to this structure.

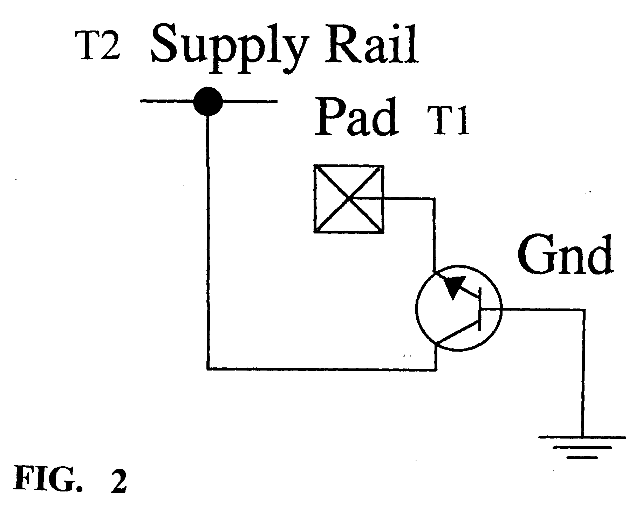

Shown in Figure 2 is the circuit that, in accordance with this invention, can provide ESD protection for the input and output terminals of an integrated circuit having an epitaxial layer, and is immune to latch-up and electromagnetic interference.

A bipolar transistor Q1 of the NPN type is connected between a terminal (Pad) T1 to be protected and a supply line (Supply Rail) T2 which, in general, would be the main supply line to the integrated circuit.

The transistor emitter is connected to the terminal T1, the collector to the line T2, and the base to the circuit ground GND.

This protection circuit is, by its very construction, unaffected by parasitic disturbances that might alter the functionality of the circuit connected to the pad. In particular, the pad is screened from any outside source of disturbance by that the transistor collector, and hence the epitaxial well of the protector itself, is connected directly to the power supply. In this way, any incoming disturbance to the pad would be "diverted" to the power supply. In addition, this connection provides immunity to latch-up problems.

The inventive structure should be designed to ensure that the emitter/base junction of the transistor would not be degraded by the electrostatic discharge if forced into breakdown.

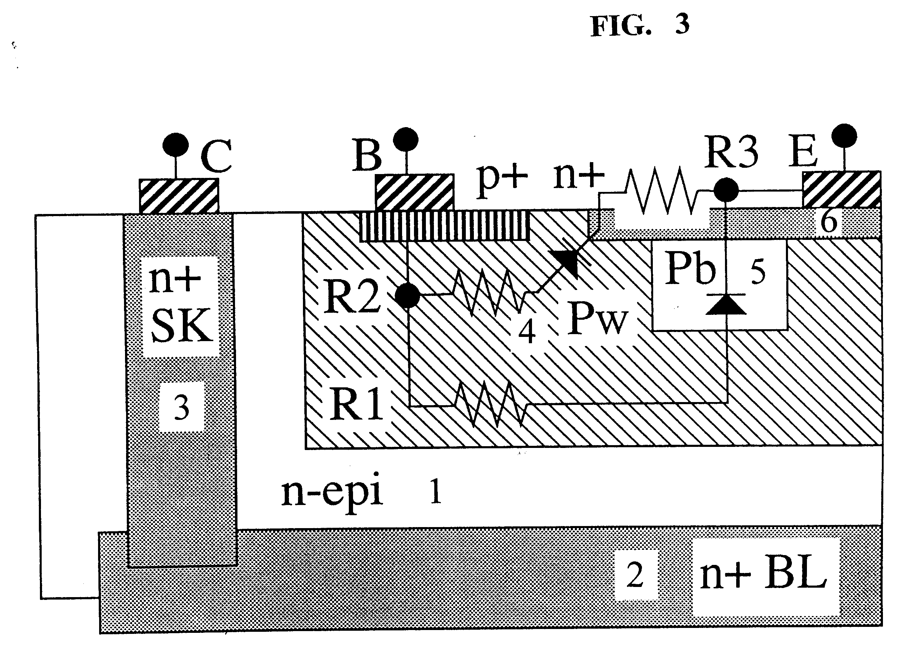

Figure 3 shows in cross-section a possible embodiment of the protection structure of this invention, in a circuit which may be integrated with a mixed technology, but not limited thereto.

The structure can be formed on a monocrystalline silicon die consisting of a substrate doped with impurities of the P type, not shown in the figure, which is overlaid by an epitaxial layer 1 doped with impurities of the N type, having a thickness of 8 to 10µm and resistivity in the 1.5 Ohm*cm range.

During the growing of the epitaxial layer 1 by conventional techniques, a buried layer 2 is formed which is more heavily doped (N⁺) than the remainder of the layer, and connected to the surface by a sinker region 3, also of the N⁺ type.

Formed over the buried layer 2 within the epitaxial layer 1 is a surface region of the P type comprising two regions, designated 4 and 5. The (P-well) region 4 is formed here by boron implantation, at an implant dosage of 8x10¹² cm⁻² to 1.2x10¹³ cm⁻² and to a junction depth of about 3.5µm. The region 5 (P-body) is formed in the P-well region 4 at a higher impurity concentration, in this case by boron implantation at a dosage of 1x10¹³ cm⁻² to 3x10¹³ cm⁻² and to a depth of about 1.25µm. An N-type region, designated 6 and extending through the P-body region from the front major surface of the die, is formed by arsenic implantation at a dosage of approximately 1x10¹⁵ cm⁻² and to a junction depth of about 1µm.

Suitable means of electrical connection, designated B, C and E, consisting in part of diffused regions of the P⁺ and N⁺ types and in part of paths of an electrically conductive material, such as aluminum or doped polycrustalline silicon (pads), are respectively formed in the regions 4, 3 and 6, in ohmic contact therewith and with the same polarity.

Thus, the protection circuit structure shown in Figure 2 is fabricated in a very simple manner.

The transistor Q1, connected between the terminal T1 to be protected, the ground GND, and the supply line T2, consists of the NPN succession of the regions 6, 5, 4 and 2, wherein the N⁺ region 6 is the emitter, the P-body region 5 and P-well region 6 are the base, and the epitaxial layer 1 with the buried layer 2 is the collector.

The cross-section shown in Figure 3 only depicts a meaningful portion of the overall protection structure according to the invention, which is derived from a conventional P-well buried base transistor.

The remaining portion, omitted for simplicity of illustration, is quite symmetrical about the emitter pad.

The ESD protection structure of this invention is primarily characterized by the addition of a ring-shaped P-body diffusion 5 which is fully enclosed within the base diffusion 4.

The N⁺ emitter diffusion 6 involves an area which is broader throughout than the ring-shaped P-body, so that the latter will be completely overlaid by it.

In addition, the emitter pad is formed in an area of the N⁺ diffusion 6 which lies inside the ring-shaped P-body 5, and is therefore unblanketed by the P-body.

By arranging for the P-body diffusion to lie fully beneath the N⁺ emitter region, the advantage can be secured of having a flat buried junction area provided as an area of possible avalanche conduction for the emitter-base junction.

Thus, the invention can provide enhanced electrostatic discharge strength, raising the structure failure threshold with respect to where the avalanche conduction is triggered at the surface and lateral junction between the N⁺ emitter region and the P-well.

The likelyhood of such triggering occurring between the emitter region and the P-well is further diminished by the emitter pad being placed, according to the invention, in an opposite area from the base pad with respect to the P-body diffusion.

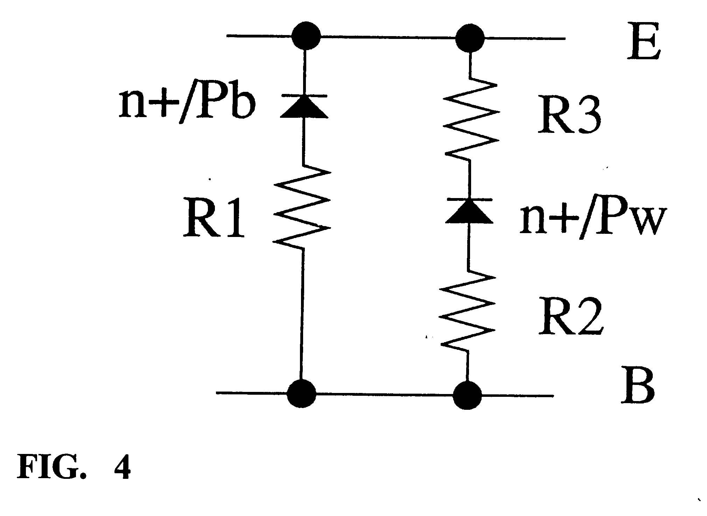

Figure 4 shows, in relation to Figure 3, an equivalent circuit of the transistor emitter-base junction; it can be appreciated that the current path through the emitter and P-well junction is disfavored by the resistor R3.

Modifications or substitutions may, of course, be made conventionally unto the exemplary embodiment described hereinabove by the skilled persons in the art.

## Claims

1. An electrostatic discharge protection circuit monolithically integratable to an integrated circuit device having at least one input terminal and at least one output terminal, characterized in that it comprises at least one transistor (Q1) having first and second terminals and a control terminal, said transistor being connected between one of said input and output terminals and a supply line to the integrated circuit, respectively through the first and second terminals thereof, and having its control terminal connected to a ground of the integrated circuit.

2. A protection circuit according to Claim 1, characterized in that the transistor is an NPN type of transistor, and the first, second, and control terminals are its emitter, collector and base terminals, respectively.

3. A transistor structure for protecting a terminal of an integrated circuit from electrostatic discharges, formed in a substrate (1) of a semiconductor material with conductivity of a first type (N), comprising a first region (4) with conductivity of a second type (P) opposite the first and extending in the substrate from a surface thereof, a second region (6) with conductivity of the first type (N⁺) and extending in said first region from said surface, a third region (2) with higher conductivity of the first type (N⁺) than the substrate, where at least a fourth region (3) is buried in an area beneath the first region (4), said fourth region having higher conductivity of the first type (N⁺) than the substrate and extending in the substrate (1) from said surface to the third region (2), being isolated from the first region (4) throughout, characterized in that it comprises a fifth region (5) with higher conductivity of the second type (P⁺) than the first region (4), where it extends from the second region (6) into a ring shape to form a bipolar junction therewith in an area beneath a non-peripheral portion of said second region (6).

4. A transistor structure according to Claim 2, wherein a base pad (B) is defined in the uncovered portion of the first region (4) by the second region (6), an emitter pad (E) is defined in the second region (6), and a collector pad (C) is defined in the fourth region (3), characterized in that the emitter pad (E) is defined in a portion of the second region (6) located within the area that overlies the portion of the first region (4) included within the ring formed by the fifth region (5).

5. A protection circuit according to either Claim 1 or 2, characterized in that the transistor therein has the structure of Claim 4.

6. A semiconductor device, comprising at least one integrated circuit having at least one terminal protected from discharges by a protection circuit according to any of Claims 1 and 5.
